# EUROPÄISCHE PATENTANMELDUNG

(11) **EP 0 528 276 A1**
(43) Veröffentlichungstag der Anmeldung: **24.02.1993**
(21) Anmeldenummer: 92113374.0
(22) Anmeldetag: 05.08.1992
(51) Int. Cl.: H05K 7/16

(54) **Elektronisches Gerät**

(30) Priorität: 19.08.1991 DE 9110232 U
(71) Anmelder: SIEMENS AKTIENGESELLSCHAFT, D-80333 München (DE)
(72) Erfinder: Mauch, Richard, W-7514 Eggenstein-Leopoldshafen (DE)

(57) **Zusammenfassung**

Die Erfindung betrifft ein elektronisches Gerät, das als Steckblock in einem Baugruppenträger montierbar ist und Flachbaugruppen (1 und 2) enthält. Bei der Montage werden diese mit ersten Abstandsbolzen (3) vormontiert, in eine einseitig offene, schlitzförmige Ausnehmung (7) an einem Stützblech (6) eingehängt und mit einem Trägerblech (5) verschraubt. Die Montage ist dadurch sehr einfach und Optionen können leicht nachgerüstet werden.

Die Erfindung wird angewandt bei Automatisierungsgeräten.

## Beschreibung

Die Erfindung bezieht sich auf ein elektronisches Gerät nach dem Oberbegriff des Anspruchs 1.

Bei modularen Aufbausystemen ist es üblich, kleinere elektronische Geräte als Steckblöcke für Baugruppenträger auszuführen. In derartigen Steckblöcken können mehrere Flachbaugruppen, aber auch in anderer Form ausgebildete Einheiten zu einer Funktionseinheit zusammengefaßt werden. Häufig befinden sich an den Flachbaugruppen Messerleisten, die im gesteckten Zustand über Federleisten, die sich auf der Rückwand des Baugruppenträgers befinden, die erforderlichen elektrischen Verbindungen in dem Aufbausystem herstellen. Daher müssen beim Stecken bzw. Ziehen des Steckblocks sogenannte Steck- und Ziehkräfte überwunden werden, die zu einem Durchbiegen der Flachbaugruppen führen können. Ein solches Durchbiegen ist aber besonders bei Flachbaugruppen mit oberflächenmontierten Bauelementen nur in sehr geringem Umfang zulässig.

Um derartige elektronische Geräte an verschiedene Anforderungen anpaßbar zu gestalten, wird zudem gefordert, daß sie mit zusätzlichen Optionen, d. h. Bausteinen zur individuellen Leistungserweiterung, nachrüstbar sind. Das Nachrüsten ist aber bei vielen Geräten erst nach vollständigem Zerlegen des Gerätes möglich.

Der Erfindung liegt die Aufgabe zugrunde, ein elektronisches Gerät zu schaffen, bei dem ein Durchbiegen der Flachbaugruppen durch Steck- und Ziehkräfte weitgehend vermieden wird und das auf einfache Weise mit Optionen nachrüstbar ist.

Zur Lösung dieser Aufgabe weist das neue elektronische Gerät der eingangs genannten Art die im kennzeichnenden Teil des Anspruchs 1 genannten Merkmale auf. Besonders vorteilhafte Ausführungsformen sind den Ansprüchen 2 bis 6 zu entnehmen.

Die Erfindung hat den Vorteil, daß durch die Zusammenfassung mehrerer Flachbaugruppen zu einer Gruppe und die Montage dieser Gruppe auf einem Trägerblech eine wesentlich höhere Biegesteifigkeit im Vergleich zu einer einzelnen Flachbaugruppe der Anordnung erreicht wird. Das Stützblech, das in die Gruppe hineinragt und in dessen Nut mindestens ein erster Abstandsbolzen einhakt, verhindert, daß beim Stecken oder Ziehen des Steckblocks das Trägerblech um die an der Frontplatte anliegende Kante gebogen wird. Die auftretenden Steck- und Ziehkräfte werden von der Gruppe über das Stützblech direkt auf die Frontplatte des elektronischen Geräts eingeleitet.

Weiterhin besticht das elektronische Gerät durch eine einfache Montage. Besonders, wenn interne Stecker elektrische Verbindungen zwischen zwei Flachbaugruppen herstellen sollen, ist es vorteilhaft, daß die Flachbaugruppen außerhalb des elektronischen Geräts zu der Gruppe vormontiert werden können und als Gruppe in das elektronische Gerät einsetzbar sind. Das elektronische Gerät ist leicht mit Optionen nachrüstbar, da lediglich die Flachbaugruppen demontiert werden müssen, auf denen diese unterzubringen sind.

Anhand der Zeichnungen, in denen ein Ausführungsbeispiel der Erfindung dargestellt ist, werden im folgenden die Erfindung sowie Ausgestaltungen und Vorteile näher erläutert.

Es zeigen:
- Figur 1: einen Ausschnitt eines elektronischen Geräts,
- Figur 2: eine Explosionszeichnung der Befestigungselemente und
- Figur 3: eine Ausnehmung im Stützblech mit Abstandsbolzen.

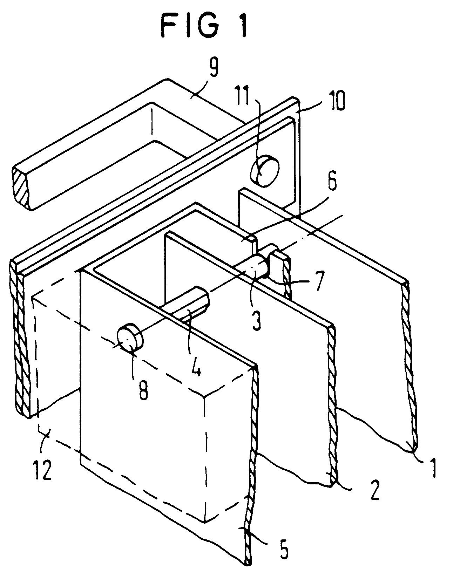

Ein elektronisches Gerät besteht nach Figur 1 aus einem Griff 9, der auf eine Frontplatte 10 montiert ist. Im eingesteckten Zustand des elektronischen Geräts ist lediglich die dem Griff 9 zugewandte Seite der Frontplatte 10 sichtbar, die in der Figur 1 nicht dargestellte Bedien- und Anzeigeelemente enthalten kann. Zur Befestigung im Baugruppenträger ist das elektronische Gerät an der Frontplatte 10 mit Bohrungen 11 für Verriegelungsschrauben versehen. Flachbaugruppen 1 und 2 sind mit ersten Abstandsbolzen 3 zu einer Gruppe zusammengefaßt und in Ausnehmungen 7 an einem Stützblech 6 eingehängt. Gleichzeitig ist die Gruppe mit zweiten Abstandsbolzen 4 und Schrauben 8 an einem Trägerblech 5 befestigt. Auf der Rückseite des Trägerblechs 5 können in einem Bereich 12 weitere, beliebig geformte Bausteine untergebracht werden.

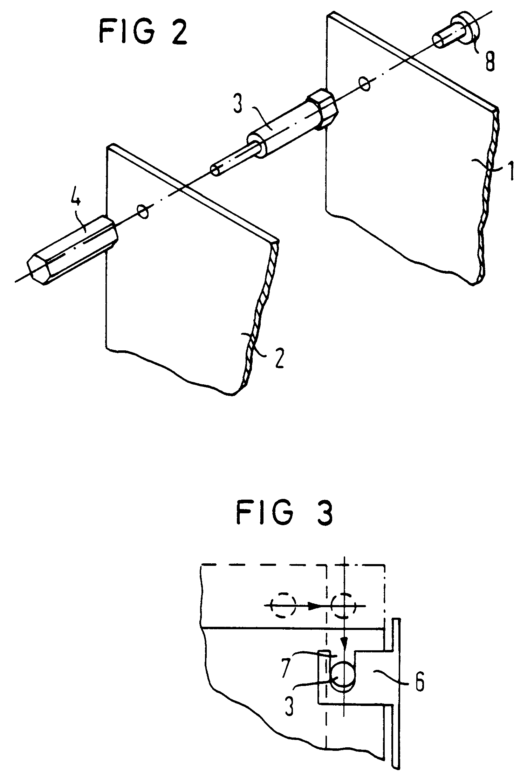

In Figur 2 sind die Befestigungselemente in einer Explosionszeichnung dargestellt. Zur Montage werden zunächst die zweiten Abstandsbolzen 4 in ein hier nicht gezeigtes Werkzeug eingelegt, das den Positionen der Befestigungsbohrungen entsprechende Ausnehmungen aufweist. Die Flachbaugruppe 2 wird darübergelegt und die ersten Abstandsbolzen 3 in die Innengewinde der zweiten Abstandsbolzen 4 eingedreht. Danach kann die Flachbaugruppe 1 aufgelegt und mit den Schrauben 8 befestigt werden. Die auf diese Weise vorgefertigte Gruppe mit den zweiten Abstandsbolzen 4 wird mit einem ersten Abstandsbolzen 3 in die Ausnehmung 7 des Stützblechs 6 eingehängt, so daß die zweiten Abstandsbolzen 4 mit ihrem Innengewinde exakt über den Befestigungsbohrungen im Trägerblech 5 zu liegen kommen. Die Schrauben 8 sind zur Befestigung der Gruppe nun leicht eindrehbar.

In Figur 3 wird gezeigt, daß die Gruppe mit einem im Bereich der Ausnehmung 7 runden, ersten Abstandsbolzen 3 bei der Montage sehr einfach in das Stützblech 6 eingehängt werden kann. Dazu muß die nutenförmige Ausnehmung 7 des Stützblechs 6 einseitig offen sein.

Muß an einem bereits fertigmontierten Gerät eine Option nachgerüstet werden, so wäre bei einem anderen Aufbau unter Umständen das gesamte Gerät zu zerlegen. In dieser Anordnung genügt es, eventuell vorhandene Verschraubungen zwischen Steckern auf der Flachbaugruppe 1 und der Frontplatte 10 zu entfernen und die nach dem Ziehen des Steckblocks gut zugänglichen Schrauben 8 auf der Flachbaugruppe 1 zu lösen. Danach kann die außenliegende Flachbaugruppe 1 abgenommen und mit der Option nachgerüstet werden. Muß an der innenliegenden Flachbaugruppe 2 gearbeitet werden, so sind nach Entfernen der äußeren Flachbaugruppe 1 die zwischen den Flachbaugruppen 1 und 2 liegenden, nun ebenfalls leicht zugänglichen ersten Abstandsbolzen 3 abzuschrauben und die Flachbaugruppe 2 abzunehmen. Die zweiten Abstandsbolzen 4 am Trägerblech 5, deren Schrauben 8 möglicherweise nicht zugänglich sind, können angeschraubt bleiben. Am übrigen Teil des elektronischen Gerätes ist bei einer Nachrüstung daher keine Demontage erforderlich. Nach erfolgter Nachrüstung kann das Gerät wieder in umgekehrter Reihenfolge montiert werden.

Zur besseren Übersichtlichkeit wurde ein Ausführungsbeispiel der Erfindung mit zwei Flachbaugruppen, einem Stützblech und einer Ausnehmung im Stützblech dargestellt. Dies soll jedoch nicht als Einschränkung verstanden werden.

## Patentansprüche

1. Elektronisches Gerät, das insbesondere als Steckblock in einem Baugruppenträger montierbar ist, mit Flachbaugruppen, **dadurch gekennzeichnet,**
- daß mindestens zwei Flachbaugruppen (1, 2) jeweils in vorgegebenem Abstand durch erste Abstandsbolzen (3) miteinander zu einer Gruppe verbunden sind,
- daß die Gruppe parallel zur Steckrichtung mit zweiten Abstandsbolzen (4) auf einem Trägerblech (5) montiert ist und
- daß mindestens ein Stützblech (6) vorhanden ist, das in die Gruppe hineinragt und in mindestens einer Ausnehmung (7) einen ersten Abstandsbolzen (3) aufnimmt, so daß eventuell auftretende Steck- und Ziehkräfte von der Gruppe auf das Stützblech (6) übertragen werden.

2. Elektronisches Gerät nach Anspruch 1, **dadurch gekennzeichnet,**
- daß die ersten Abstandsbolzen (3) auf der dem Trägerblech (5) abgewandten Seite ein Innengewinde besitzen und
- daß die erste Flachbaugruppe (1) der Gruppe, die sich auf der dem Trägerblech (5) abgewandten Seite befindet, im elektronischen Gerät leicht zugänglich ist und mit Schrauben (8) auf den ersten Abstandsbolzen (3) befestigt ist.

3. Elektronisches Gerät nach Anspruch 2, **dadurch gekennzeichnet,**
- daß die ersten Abstandsbolzen (3) auf der dem Trägerblech (5) zugewandten Seite ein Außengewinde besitzen und
- daß weitere Flachbaugruppen (2) der Gruppe mit ersten Abstandsbolzen (3) auf ersten Abstandsbolzen (3) oder, wenn es die Flachbaugruppe (2) auf der dem Trägerblech (5) zugewandten Seite ist, auf zweiten Abstandsbolzen (4) befestigt sind, die auf beiden Seiten ein Innengewinde aufweisen.

4. Elektronisches Gerät nach Anspruch 3, **dadurch gekennzeichnet,**
- daß die Gruppe mit den zweiten Abstandsbolzen (4) durch Schrauben (8) auf dem Trägerblech (5) befestigt ist.

5. Elektronisches Gerät nach einem der vorhergehenden Ansprüche, **dadurch gekennzeichnet,**
- daß mindestens die ersten Abstandsbolzen (3), die sich in der Ausnehmung (7) eines Stützblechs (6) befinden, im Bereich der Ausnehmung (7) rund sind.

6. Elektronisches Gerät nach einem der vorhergehenden Ansprüche, **dadurch gekennzeichnet,**
- daß Trägerblech (5) und Stützblech (6) aus einem Blech gefertigt sind.
